**Europäisches Patentamt**

**European Patent Office**

**Office européen des brevets**

(19)

(11) Veröffentlichungsnummer : **0 542 711 A1**

## (12) EUROPÄISCHE PATENTANMELDUNG

(21) Anmeldenummer : **92890239.4**

(22) Anmeldetag : **06.11.92**

(51) Int. Cl.$^5$ : **H03D 7/16**

(30) Priorität : **13.11.91 AT 2246/91**

(43) Veröffentlichungstag der Anmeldung :
**19.05.93 Patentblatt 93/20**

(84) Benannte Vertragsstaaten :
**CH DE DK GB LI**

(71) Anmelder : **VIENNATONE Gesellschaft m.b.H.
Fröbelgasse 28-32
A-1164 Wien (AT)**

(72) Erfinder : **Ribic, Zlatan, Dr.
Anton-Baumgartner 44/A8/52
A-1230 Wien (AT)**

(74) Vertreter : **Kliment, Peter, Dipl.-Ing. Mag.-jur.
Singerstrasse 8/3/8
A-1010 Wien (AT)**

(54) **Verfahren zur Verschiebung der Frequenz von Signalen.**

(57)    Verfahren und Vorrichtung zur Transposition der Frequenz eines Eingangssignales, insbesondere für Hörgeräte, mit :
— einer analytischen Schaltung (AS) , mit der ein momentanes Frequenzsignal w(t), dessen Stärke proportional der momentanen Frequenz des Eingangssignales $u_i$(t) und ein momentanes Amplitudensignal A(t), dessen Stärke proportional der momentanen Amplitude des Eingangssignales $u_i$(t) ist, erzeugbar sind,
— einem spannungsgesteuerten Oszillator (VCO), der an dem das Frequenzsignal w(t) liefernden Ausgang der analytischen Schaltung (AS) angeschlossen ist.
— einem Multiplizierer (M) mit zwei Eingängen, von denen einer an den Ausgang des spannungsgesteuerten Oszillators (VCO) und der andere an dem das Amplitudensignal A(t) liefernden Ausgang der analytischen Schaltung (AS) angeschlossen ist.

Fig. 4

EP 0 542 711 A1

Die Erfindung betrifft ein Verfahren zur Verschiebung der Frequenz von Signalen.

Moderne elektro-akustische Übertragungsanlagen, von der Saal-Beschallungsanlage bis zum Hörgerät für Schwerhörige, erfüllen in der Regel mehrere Hauptfunktionen, wie z.B.:
- Verstärken,
- Filtern,
- Regulieren der Dynamik (AGC-,ASP-Systeme).

Bei allen diesen Vorgängen bleibt die Ausgangssignalfrequenz im wesentlichen gleich der Eingangssignalfrequenz. Die Übertragungsanlage selbst erzeugt im Idealfall keine neuen Signalkomponenten. In der Praxis sind im Ausgangssignal allerdings Verzerrungen und Rauschanteile enthalten. Diese Veränderungen sind störend und unerwünscht und man trachtet, ihren Anteil so klein wie möglich zu halten.

Grundsätzlich kann behauptet werden:

$$u_o(t) = K\, u_i(t - T_o) + K_n\, n\, u_i(t - T_o) + N + IM$$

wobei: $u_o(t)$ = Ausgangssignal zum Zeitpunkt t, K = momentane Verstärkung, $u_i(t)$ = Eingangssignal zum Zeitpunkt t, $T_o$ = Verzögerungszeit, $K_n$ = Verzerrungsfaktor, n = 2,3,... , N = Rauschen, IM = Intermodulation bedeuten.

Der erste Term der rechten Seite der Gleichung stellt dabei das Nutzsignal dar. Der zweite Term betrifft die unter Umständen auftretenden Harmonischen.

Alle Komponenten des Eingangssignals bleiben im Spektrum des Ausgangssignals an der gleichen Stelle, d.h. die Frequenz bleibt gleich.

Nun kann es aber für bestimmte Zwecke vorteilhaft sein, das Spektrum der Frequenzen so zu transponieren, daß das Spektrum der Ausgangsfrequenzen gegenüber den Eingangsfrequenzen mehr oder weniger stark verschoben ist. Eine sehr wichtige praktische Anwendung der Frequenztransposition wäre z.B. Unterdrückung akustischer Rückkopplung bei großer Verstärkung. Durch die Frequenzverschiebung werden die Rückkoppelungsprobleme bei großer Verstärkung reduziert oder überhaupt egalisiert. Die Erklärung dafür ist sehr einfach. Wegen der Frequenzverschiebung des Ausgangssignals gegenüber dem Eingangssignal kommt es im Falle einer Rückkopplung an den Eingang zu keinem aufschaukelnden Effekt, da das Ausgangssignal ja immer geringfügig anders aussieht als das Eingangssignal. Außerdem wird das bereits frequenzverschobene Signal bei jedem weiteren Durchlauf immer weiter aus dem hochverstärkten Übertragungsbereich in einen Bereich geringer Verstärkung verschoben. Schon eine kleine Transposition bringt so einige dB mehr an nutzbarer Verstärkung.

Eine weitere sehr wesentliche Anwendung bietet sich in Hörgeräten für Schwerhörige an: Es gibt Versuche die Sprachinformation (Eingangssignal) in der spektralen Position (Frequenz) zu verschieben, um das Signal in den Bereich der Hörreste eines Schwerhörigen zu transponieren, damit dieser die Gesamtinformation wieder hören kann. Die Frequenzverschiebung ermöglicht dem Schwerhörigen, wieder jene wichtigen Informationen wahrzunehmen, die vorher außerhalb des für ihn hörbaren Bereichs lagen. Häufig tritt ja Schwerhörigkeit im höheren Frequenzbereich weit stärker auf als im niedrigeren. Durch Verschiebung des Nutzsignals in diesen niedrigeren Frequenzbereich kann auch bei massivsten Hörverlusten dem Schwerhörigen geholfen werden.

In weiterer Folge stellt sich die Problematik der Frequenzverschiebung bei der Übertragung von Daten über Telefonleitungen und dgl. Dabei kann es unter Umständen erwünscht sein, ein bereits mittels eines Modems moduliertes Signal in seiner Frequenz zu verschieben, ohne den Informationsinhalt zu gefährden.

Eine langsamer wiedergegebene Sprachaufnahme, wie wir es z.B. vom Tonbandgerät her kennen, ist grundsätzlich gut verständlich, solange dar Transpositionsfaktor ein gewisses Maß nicht überschreitet. Daher wäre dieses Verfahren für eine Frequenztransposition ideal. In diesem Zusammenhang ist ein Verfahren mit rotierenden Tonköpfen bekannt, welches sich aber als fehlerbehaftet erwies, da dabei einerseits einige Zeitsegmente verloren gingen und andererseits an eine Echtzeit-Anwendung erst gar nicht zu denken war.

Weiters wurde erwogen, eine Fast Fourier Transformations-Analyse (kurz FFT genannt), Frequenzverschiebung und inverse FFT vorzusehen. Diese Methode ist denkbar, aber sehr aufwendig und scheitert heute meist an einer Realisierung als integrierte Schaltung in geringer Baugröße.

In der Folge wurde vorgeschlagen, durch mehrere Filter eine approximative Frequenzanalyse des Signals durchzuführen, um etwa die Signalanteile zwischen 200 und 400 Hz, zwischen 400 und 650 Hz usw., zu bestimmen. Wenn nun mit diesen Signalanteilen jeweils ein Oszillator angesteuert wird, so kann man eine Frequenzverschiebung dadurch realisieren, daß der Oszillator auf eine Frequenz außerhalb des zugehörigen Bereiches abgestimmt ist. Eine solche Schaltung, das Vocodersystem nach Pimonov, ist in A. Constam: "Einige Betrachtungen über Transpositionssysteme", beschrieben. Eine derartige Vorrichtung ist bei der Verwendung von wenigen Filtern nicht in der Lage ein brauchbares Signal zu erzeugen. Werden jedoch ausreichend viele Filter verwendet, so ist der Schaltungsaufwand zu groß für viele praktische Anwendungen.

Ferner ist es aus M. H. Jones: Frequency Shifter For "Howl" Suppression, in: Wireless World, Juli 1973, bekannt, eine Frequenzverschiebung um einen festen Betrag, etwa 5 Hz durchzuführen. Es ist jedoch damit nicht möglich größere Verschiebungen durchzuführen, da die Tonintervalle verändert werden.

Sprache wird dadurch schon bei mäßigen Verschiebungen unverständlich.

Kurz gesagt, es ist bis heute noch keine effektive Methode zur Frequenztransposition bekannt. Obwohl mittlerweile die Digitaltechnik bis in die Hörgerätetechnik vorgedrungen ist, kann diese nicht zur reinen und komplexen Signalbearbeitung genutzt werden.

Aufgabe der Erfindung ist es, diese Nachteile zu vermeiden und ein Verfahren und eine Schaltung der eingangs erwähnten Art vorzuschlagen, die auf einfache Weise und mit geringem schaltungstechnischem Aufwand eine Frequenztransposition in Echtzeit ermöglicht.

Eine weitere Aufgabe besteht darin ein Verschiebungsverfahren zu entwickeln, bei dem die Tonintervalle im wesentlichen unverändert erhalten bleiben. Dies bedeutet, daß eine logarithmische Frequenzverschiebung vorliegen soll.

Erfindungsgemäß sind folgende Schritte vorgesehen:

- Erzeugung eines analytischen Signales, bestehend aus zwei Hilbert-Signalen $h_1(t)$, $h_2(t)$, dessen Energiespektrum dem des Eingangssignales $u_i(t)$ entspricht;
- Differenzierung und Verknüpfung der Hilbert-Signale $h_1(t)$ und $h_2(t)$ zur Erzeugung eines momentanen Frequenzsignales $w(t)$;
- Erzeugung eines Ausgangssignales $u_o(t)$ bzw. $v_o(t)$, dessen momentane Frequenz jeweils dem momentanen Frequenzsignal $w(t)$ entspricht.

Als analytisches Signal wird ein komplexes Signal bezeichnet, dessen imaginäre Komponente die Hilbert-Transformierte der realen Komponente darstellt. Die mathematischen Grundlagen sind bekannt und etwa in R. B. Randall: "Frequency Analysis", Brüel & Kjaer, 1987 ausführlich beschrieben. Wegen dieser Eigenschaft werden in der Folge die beiden Komponenten des analytischen Signals kurz als Hilbert-Signale bezeichnet.

Je nach der Abstimmung der Schaltung, auf der dieses Verfahren durchgeführt wird, besitzt das Ausgangssignal eine Frequenz, die höher oder niedriger als die des Eingangssignales ist. Jedenfalls aber ist die Frequenz des Ausgangssignales um einen multiplikativen Faktor verschoben. Daher bleiben sämtliche Tonintervalle unverändert erhalten. Ein solches Verfahren ist schaltungstechnisch sehr einfach zu implementieren und es hat sich gezeigt, daß die transponierten Signale sehr gut verständlich sind.

Es kann vorgesehen sein, daß das momentane Frequenzsignal $w(t)$ einer Regelung oder Steuerung unterworfen wird. Auf diese Weise ist das Ausmaß der Frequenzverschiebung veränderlich. Die Regelung kann manuell über ein Potentiometer, etwa durch den Träger eines Hörgerätes, oder in Abhängigkeit von der Lautstärke erfolgen.

Es ist möglich, daß das momentane Frequenzsignal $w(t)$ nichtlinear verstärkt oder abgeschwächt wird. Damit wird zwar der Weg verlassen, eine Verschiebung um einen konstanten Frequenzfaktor durchzuführen, aber es ist auf diese Weise möglich, das Frequenzspektrum zu komprimieren. Dies kann beispielsweise bei extremer Schwerhörigkeit der einzige Weg sein, die gesamte Sprachinformation in ein enges verbliebenes Frequenzfenster zu transponieren. Auch bei der Datenübertragung kann eine solche Vorgangsweise erforderlich sein. Durch das nichtlineare Glied ist es auch sehr einfach möglich höhere Frequenzen des Eingangssignales stärker in Richtung tieferer Frequenzen zu verschieben, als z.B. mittlere Frequenzen des Hörbereiches. Auf diese Weise ist es möglich, bestimmte Frequenzbereiche des Eingangssignales mehr zu verändern als andere Frequenzbereiche. Dies ist besonders für eine Anwendung der erfindungsgemäßen Schaltung bei Hörgeräten für Schwerhörige von Bedeutung. So verläuft ein Hörverlust meist nicht linear über den gesamten Frequenzbereich, sonderen der Hörverlust tritt verstärkt im Bereich höherer Frequenzen auf.

Es können so die weniger geschädigter Hörbereiche des Benutzers ausgenutzt werden und die aufgenommenen Schallsignale über einen über die erfindungsgemäße Schaltung angesteuerten Hörer verstärkt in jenen Frequenzbereichen abgestrahlt werden, in denen der Benutzer sein größtes Hörvermögen aufweist.

Bei Audio-Signalen ist ein Teil der übertragenen Information in der Amplitude enthalten. Bei der Verschiebung der Frequenz von Audio-Signalen $u(t)$, insbesonders für Hörgeräte, ist es vorteilhaft, wenn das Ausgangssignal $v_o(t)$ mit einem spannungsgesteuerten Oszillator (VCO) erzeugt wird und im Anschluß mit einem momentanen Amplitudensignal $A(t)$ multipliziert wird, dessen momentane Stärke im wesentlichen proportional der momentanen Amplitude des Eingangssignales $u_i(t)$ ist. Das nach einem solchen Verfahren erzeugte Signal entspricht bis auf die Frequenzverschiebung dem Eingangssignal.

Vorzugsweise wird das momentane Amplitudensignal $A(t)$ vor der Multiplikation nichtlinear verstärkt oder abgeschwächt. Damit kann die Dynamik gezielt verändert werden. Je nach Bedarf kann eine Kompression oder Expansion erfolgen. Im Fall von Hörgeräten hat sich herausgestellt, daß eine Kompression, bei der Signale geringer Amplitude in der Zeitdomäne und in der Frequenzdomäne stärkere Spektralkomponenten überproportional verstärkt werden, eine vorteilhafte Unterdrückung von Störgeräuschen ermöglicht. Ein gewichtiger Vorteil besteht beim erfindungsgemäßen Verfahren darin, daß keine Ein- und Ausschwingzeiten auftreten.

Das momentane Frequenzsignal $w(t)$ kann mit folgenden Schritten in vorteilhafter Weise erzeugt werden:

- Erzeugung eines analytischen Signales, bestehend aus zwei Hilbert-Signalen $h_1(t)$, $h_2(t)$, dessen Energiespektrum dem des Eingangssignales $u_i(t)$ entspricht;

- Differenzierung der beiden Hilbert-Signale $h_1(t)$, $h_2(t)$;
- Bildung der Quadratwurzel wA(t) aus der Summe der Quadrate der differenzierten Signale $d_1(t)$ und $d_2(t)$ ;
- Division des so erhaltenen Signales wA(t) durch ein momentanes Amplitudensignal A(t), dessen Stärke im wesentlichen proportional zur momentanen Amplitude des Eingangssignales $u_i(t)$ ist.

Die Hilbert-Transformation erzeugt aus einer Funktion eine andere Funktion, deren Energiespektrum identisch ist, deren Phasenlage in allen Frequenzen jedoch um $\pi/2$ verschoben ist. Es wäre nun im Prinzip möglich, das Eingangssignal $u_i(t)$ einer solchen Hilbert-Transformation zu unterwerfen. Dies ist jedoch schaltungstechnisch sehr schwierig zu realisieren. Es ist jedoch ohne weiteres möglich, zwei Ausgangssignale $h_1(t)$ und $h_2(t)$ zu erzeugen, die beide im Energiespektrum mit dem Eingangssignal $u_i(t)$ übereinstimmen und deren Phasenlage untereinander um $\pi/2$ verschoben ist.

Vorzugsweise wird das momentane Amplitudensignal A(t) dadurch gewonnen, daß die Quadratwurzel aus der Summe der Quadrate der beiden Hilbert-Signale $h_1(t)$ und $h_2(t)$ gebildet wird.

Es ist in weiterer Variante auch möglich, das momentane Frequenzsignal w'(t) mit folgenden Schritten zu erzeugen:

- Erzeugung eines analytischen Signales, bestehend aus zwei Hilbert-Signalen $h_1(t)$, $h_2(t)$, dessen Energiespektrum dem des Eingangssignales $u_i(t)$ entspricht;
- Differenzierung der beiden Hilbert-Signale $h_1(t)$ und $h_2(t)$;
- Addition der Beträge der differenzierten Signale $d_1(t)$ und $d_2(t)$;
- Division des so erhaltenen Signals H(t) durch die Summe G(t) der Beträge der beiden Hilbert-Signale $h_1(t)$ und $h_2(t)$.

Dabei handelt es sich zwar nicht um ein exaktes Verfahren, aber dafür ist ein geringerer schaltungstechnischer Aufwand erforderlich. Im übrigen ist die Abweichung des angenäherten Frequenzsignales w'(t) vom exakten Signal w(t) umso kleiner je mehr eine bestimmte Frequenz im Eingangssignal dominiert.

Weiters betrifft die Erfindung eine Vorrichtung zur Verschiebung der Frequenz von Signalen u(t).

Erfindungsgemäß ist eine Frequenzsignalschaltung vorgesehen, mit der ein momentanes Frequenzsignal w(t) erzeugbar ist, sowie ein spannungsgesteuerter Oszillator, der an den Ausgang der Frequenzsignalschaltung angeschlossen ist. Die Frequenz des von diesem Oszillator erzeugten Signales ist in jedem Zeitpunkt proportional zur Stärke des Eingangssignales.

Vorzugsweise ist zwischen der Frequenzsignalschaltung und dem spannungsgesteuerten Oszillator ein Regler und/oder ein nichtlineares Übertragungsglied eingefügt.

Bei der Verwendung für Hörgeräte kann die erfindungsgemäße Vorrichtung ausgestattet sein mit:

- einer analytischen Schaltung, mit der ein momentanes Frequenzsignal w(t) und ein momentanes Amplitudensignal A(t) erzeugbar sind,
- einem spannungsgesteuerten Oszillator, der an dem das Frequenzsignal w(t) liefernden Ausgang der analytischen Schaltung angeschlossen ist,
- einem Multiplizierer mit zwei Eingängen, von denen einer an den Ausgang des spannungsgesteuerten Oszillators und der andere an dem das momentane Amplitudensignal liefernden Ausgang der analytischen Schaltung angeschlossen ist.

Es kann auch zwischen dem Multiplizierer und dem das momentane Amplitudensignal A(t) liefernden Ausgang der analytischen Schaltung ein nichtlineares Übertragungsglied vorgesehen sein. In diesem Zusammenhang kann weiters vorgesehen sein, daß dem spannungsgesteuerten Oszillator ein Mischer nachgeschaltet ist, dessen zweiter Eingang mit dem Eingang verbunden ist, wobei das nicht-lineare Glied gegebenenfalls ebenfalls mit dem Eingang der Signalteilerschaltung eingangsseitig verbunden ist.

Auf diese Weise kann das Eingangssignal dem Ausgangssignal der erfindungsgemäßen Schaltung zugemischt werden, wodurch die Verfremdung der Ausgangssignale gegenüber den Eingangssignalen vermindert werden. Dadurch wird eine zu starke Verfremdung der Sprache vermieden, die eines erhebliche Gewöhnungszeit erfordern würde. Dabei kann durch eine Beeinflussung des nicht-linearen Gliedes durch das Eingangssignal der Signalteilerschaltung eine weitere Anpassung der Charakteristik der erfindungsgemäßen Schaltung z.B. an die Bedürfnisse eines Benutzers eines Hörgerätes erreicht werden.

In der Folge wird die Erfindung anhand der in den Figuren dargestellten Ausführungsvarianten näher erläutert. Die Figuren zeigen schematisch:

Die Fig. 1 bis 4 Blockschaltbilder verschiedener Ausführungsvarianten der erfindungsgemäßen Vorrichtung;

die Fig. 5 und 6 Blockschaltbilder von Varianten der analytischen Schaltung;

die Fig. 7 ein Blockschaltbild der Hilbert-Schaltung;

die Fig. 8 eine schaltungstechnische Realisierung der Hilbert-Schaltung;

die Fig. 9 ein Blockschaltbild einer Variante der Hilbert-Schaltung;

die Fig. 10 eine schaltungstechnische Realisierung der Verknüpfungsschaltung.

die Fig. 11 bis 15 Beispiele für verschiedene Signale und Ihre Transformationen.

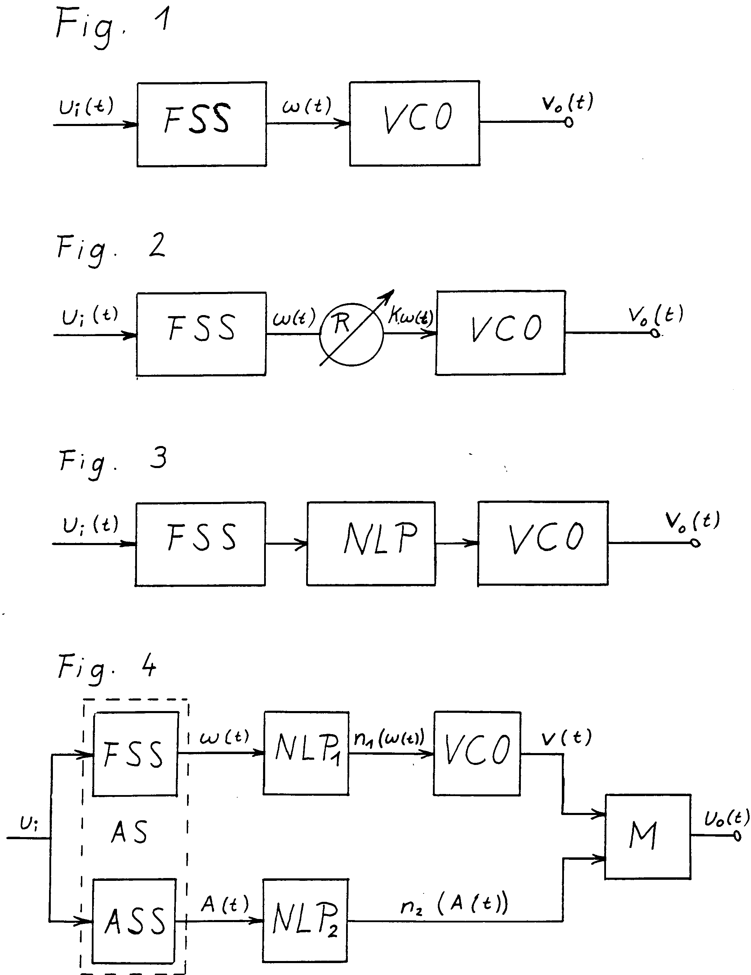

Aus der Fig. 1 ist zu erkennen, daß sich die erfindungsgemäße Vorrichtung im einfachsten Fall aus einer Frequenzsignalschaltung FSS und einem spannungsgesteuerten Oszillator VCO zusammensetzt. Die Frequenzsignalschaltung FSS erzeugt aus dem Eingangssignal $u_i(t)$ ein Frequenzsignal $w(t)$, dessen momentane Stärke im wesentlichen proportional der momentanen Frequenz des Eingangssignales $u_i(t)$ ist. Das Frequenzsignal $w(t)$ wird im spannungsgesteuerten Oszillator VCO in das Ausgangssignal $v_o(t)$ umgewandelt.

Bei der Ausführungsvariante von Fig. 2 ist ein Regler R vor den spannungsgesteuerten Oszillator VCO geschaltet, wodurch das Ausmaß der Frequenzverschiebung einstellbar ist. Dieser Regler R ist im einfachsten Fall als Potentiometer, das vom Träger des Hörgerätes eingestellt werden kann auszuführen.

In Fig. 3 ist ein nichtlineares Übertragungsglied NLP vorgesehen, um einzelne Frequenzbereiche unterschiedlich stark zu verschieben. Damit ist es beispielsweise möglich, Signalanteile mit hoher Frequenz durch eine starke Verschiebung in einen mittleren oder tiefen Frequenzbereich zu transponieren, ohne jedoch die übrigen Signalnateile allzu stark zu verschieben.

In den bisher beschriebenen Fällen ist die Amplitude des Ausgangssignals $v_o(t)$ im wesentlichen konstant und unabhängig von der Amplitude des Eingangssignals $u_i(t)$. In der Fig. 4 ist der allgemeine Fall dargestellt. Das Eingangssignal $u_i(t)$ wird einer analytischen Schaltung AS zugeführt, die ein momentanes Frequenzsignal $w(t)$ und ein momentanes Amplitudensignal $A(t)$ erzeugt. Der das Frequenzsignal $w(t)$ erzeugende Teil der analytischen Schaltung AS kann als Frequenzsignalschaltung FSS bezeichnet werden und der das Amplitudensignal $A(t)$ erzeugende Teil kann Amplitudensignalschaltung ASS genannt werden. Diese Teile können kombiniert oder getrennt ausgeführt werden.

Sowohl das momentane Frequenzsignal $w(t)$ als auch das momentane Amplitudensignal $A(t)$ werden durch nichtlineare Übertragungsglieder $NLP_1$ und $NLP_2$ verzerrt. Das am Ausgang des Übertragungsgliedes $NLP_1$ anliegende Signal $n_1(w(t))$ steuert den spannungsgesteuerten Oszillator VCO an. Das am Ausgang des spannungsgesteuerten Oszillators VCO anliegende Signal $v(t)$ wird in einem Multiplizierer M mit dem am Ausgang des Übertragungsgliedes $NLP_2$ anliegenden Signal $n_2(A(t))$ mulzipliziert.

Das Übertragungsglied $NLP_1$ beeinflußt das Ausmaß und die Art der Frequenzverschiebung, wie dies zu Fig. beschrieben worden ist. Mit dem Übertragungsglied $NLP_2$ ist eine Einstellung des Dynamikverhaltens möglich. Dabei ist bei einer unterlinearen Charakteristik von $NLP_2$ eine Kompression und bei einer überlinearen Charakteristik eine Expansion möglich. Damit ergeben sich wirksame Möglichkeiten Störgeräusche zu unterdrücken.

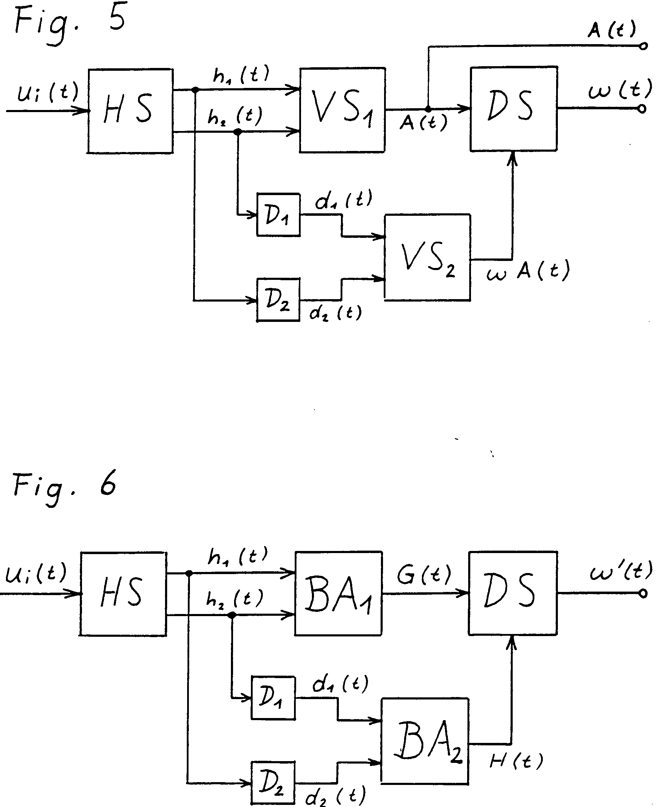

In der Fig. 5 ist eine Ausführungsvariante für die Frequenzsignalschaltung FSS dargestellt. In der Hilbert-Schaltung HS werden zwei Hilbert-Signale $h_1(t)$ und $h_2(t)$ erzeugt, die das gleiche Energiespektrum aufweisen wie das Eingangssignal $u_i(t)$ und deren Phasen um $\pi/2$ gegeneinander verschoben sind. Weiters sind zwei Differenzierglieder $D_1$ und $D_2$ vorgesehen, die an die Ausgänge der Hilbert-Schaltung HS angeschlossen sind. Eine erste Verknüpfungsschaltung $VS_1$ ist mit ihren beiden Eingängen an die Ausgänge der Hilbert-Schaltung HS angeschlossen und erzeugt bei an den Eingängen anliegenden Signalen $h_1(t)$ und $h_2(t)$ ein Ausgangssignal $A(t)$ nach folgendem Algorithmus:

$$A(t) = V \overline{h_1{}^2(t) + h_2{}^2(t)} \ ;$$

Eine zweite Verknüpfungsschaltung $VS_2$ ist mit ihren beiden Eingängen an die Differenzierglieder $D_1$ und $D_2$ angeschlossen und erzeugt bei an den Eingängen anliegenden Signalen $d_1(t)$ und $d_2(t)$ ein Ausgangssignal $wA(t)$ nach folgendem Algorithmus:

$$wA(t) = V \overline{d_1{}^2(t) + d_2{}^2(t)} \ ;$$

Eine Divisionsschaltung DS ist mit ihren Eingängen an die Verknüpfungsschaltungen $VS_1$ und $VS_2$ angeschlossen und erzeugt ein Ausgangssignal $w(t)$ nach folgender Formel:

$$w(t) = wA(t) / A(t) \ .$$

Somit ist dieses Ausgangssignal $w(t)$ ein Frequenzsignal, wie es zur Weiterverarbeitung im spannungsgesteuerten Oszillator VCO benötigt wird. Es kann jedoch das Amplitudensignal $A(t)$ nach der ersten Verknüpfungsschaltung abgegriffen werden, sodaß die in der Fig. 5 dargestellte Schaltung auch eine vollwertige analytische Schaltung AS, wie etwa in Fig. 4 benötigt, abgibt.

Die in der Fig. 6 dargestellte Ausführungsvariante der Frequenzsignalschaltung FSS weist folgende Elemente auf:

- eine Hilbert-Schaltung HS mit zwei Ausgängen, an denen zwei aus einem Eingangssignal $u_i(t)$ gewonnene Hilbert-Signale $h_1(t)$ und $h_2(t)$ anliegen, von denen ein Signal $h_1(t)$ die Hilbert-Transformation des anderen Signales $h_2(t)$ darstellt,
- zwei Differenzierglieder $D_1$ und $D_2$, die an die Ausgänge der Hilbert-Schaltung (HS) angeschlossen sind,
- einen ersten Betrags-Addierer $BA_1$, der mit seinen beiden Eingängen an die Ausgänge der Hilbert-Schaltung HS angeschlossen ist und der bei an den Eingängen anliegenden Signalen $h_1(t)$ und $h_2(t)$ ein Ausgangssignal $G(t)$ nach folgendem Algorithmus erzeugt:

$$G(t) = | H_1(t) | + | h_2(t) | \ ;$$

- einen zweiten Betrags-Addierer $BA_2$, der mit seinen beiden Eingängen an die Differenzierglieder $D_1$ und $D_2$ angeschlossen ist und der bei an den Eingängen anliegenden Signalen $d_1(t)$ und $d_2(t)$ ein Ausgangssignal $H(t)$ nach folgendem Algorithmus erzeugt:

$$H(t) = |d_1(t)| + |d_2(t)| ;$$

- eine Divisionsschaltung DS, die mit ihren Eingängen an die beiden Betrags-Addierer $BA_1$ und $BA_2$ angeschlossen ist und die ein Ausgangssignal $w'(t)$ nach folgender Formel erzeugt:

$$w'(t) = H(t) / G(t) .$$

Das Ausgangssignal $w'(t)$ stellt dabei eine Näherung für das Frequenzsignal $w(t)$ dar.

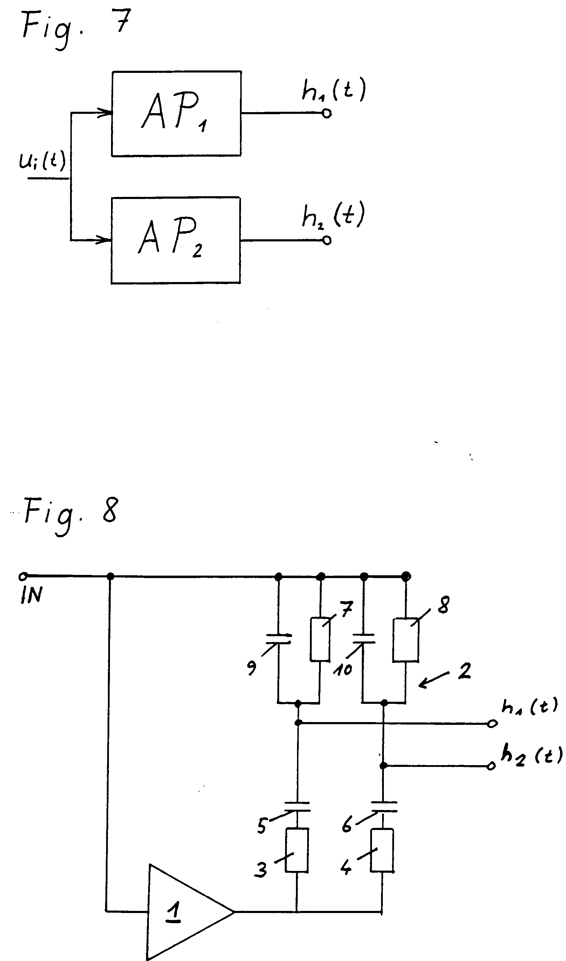

Aus der Fig. 7 geht hervor, daß die Hilbert-Schaltung HS aus mindestens zwei Allpässen $AP_1$, $AP_2$ aufgebaut sein kann. Das Übertragungsverhalten der Allpässe $AP_1$, $AP_2$ ist dabei so gewählt, daß im gewünschten Frequenzbereich an den zwei Ausgängen Hilbert-Signale $h_1(t)$ und $h_2(t)$ anliegen, von denen ein Signal $h_1(t)$ die Hilbert-Transformation des anderen Signales $h_2(t)$ darstellt.

In der Fig. 8 ist der mögliche Aufbau der Hilbert-Schaltung HS nach Fig. 7 im einzelnen dargestellt. Bei dieser ist der Eingang IN in bekannter Weise mit einem Verstärker 1 und einer Brückenschaltung 2 verbunden, deren beide Zweige mit dem Ausgang des Verstärkers 1 verbunden sind.

Die beiden Zweige der Brückenschaltung 2 sind durch je eine Reihenschaltung eines Widerstandes 3, 4 mit einem Kondensator 5, 6 und je eine mit diesem verbundene Parallelschaltung eines Widerstandes 7, 8 mit einem Kondensator 9, 10 gebildet, wobei die Bauteile in den beiden Zweigen unterschiedlich dimensioniert sind. Der Abgriff der beiden Ausgangssignale $h_1(t)$, bzw. $h_2(t)$ erfolgt an den Verbindungspunkten der Reihen-R/C Glieder mit den Parallel-R/C Gliedern. Die Widerstände und Kapazitäten sind passend zu wählen.

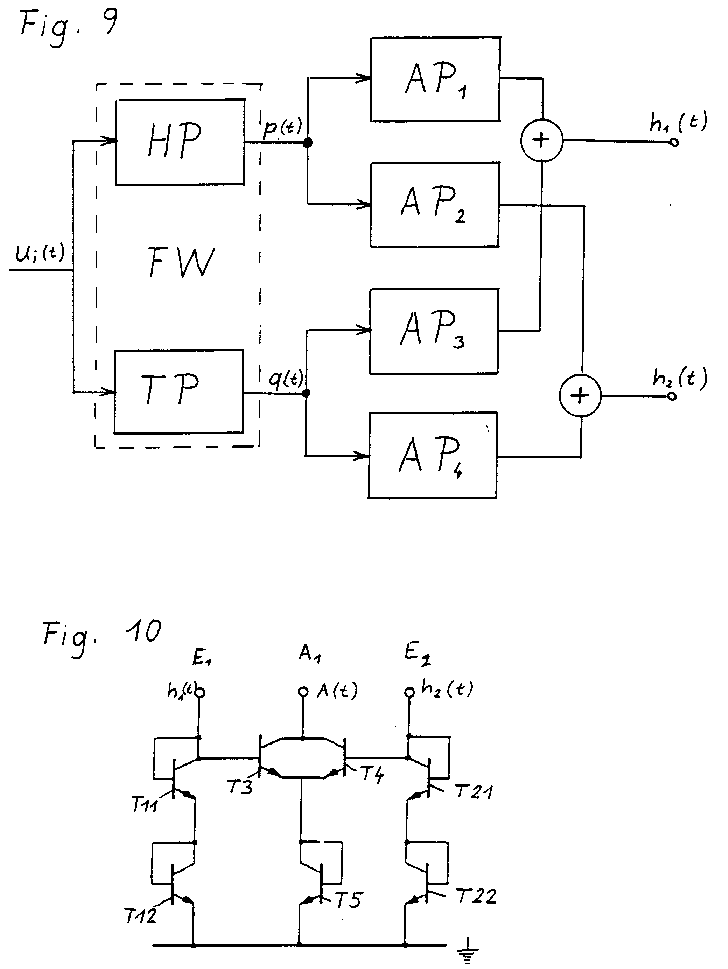

Falls mit der Schaltung nach Fig. 7 und 8 der Frequenzbereich, in dem die Hilbert-Transformation ausreichend genau durchgeführt wird, zu schmal ist, kann eine Frequenzweiche FW vorgesehen sein, die z. B. aus einem Hochpaß HP und einem Tiefpaß TP besteht, wie dies in der Fig. 9 dargestellt ist. Die Teilsignale $p(t)$ und $q(t)$ werden mittels mehrerer Paare von Allpässen $AP_1$, $AP_2$; $AP_3$, $AP_4$ getrennt transformiert und im Anschluß addiert, um die Hilbert-Signale $h_1(t)$ und $h_2(t)$ zu gewinnen.

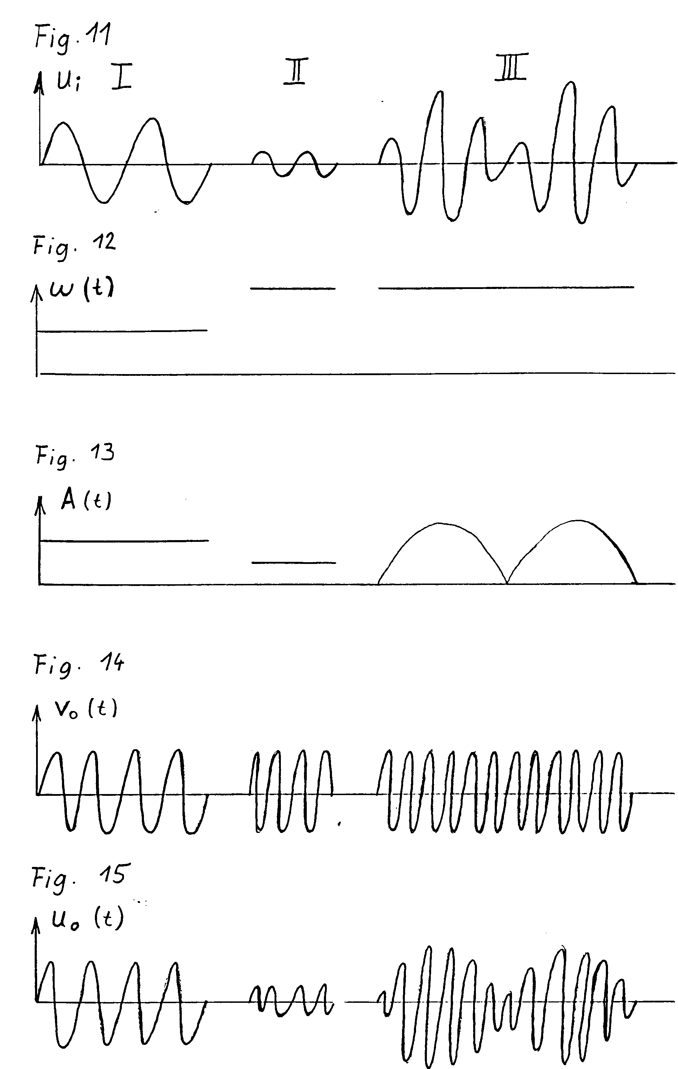

In der Fig. 10 ist eine Verknüpfungsschaltung dargestellt, die aus den an den Eingängen $E_1$ und $E_2$ anliegenden Signalen $h_1(t)$ und $h_2(t)$ am Ausgang $A_1$ das Signal:

$$A(t) = V \overline{h_1^2(t) + h_2^2(t)} ;$$

erzeugt.

In analoger Weise ist es möglich aus den an den Eingängen $E_1$ und $E_2$ anliegenden Signalen $d_1(t)$ und $d_2(t)$ am Ausgang $A_1$ das Signal:

$$wA(t) = V \overline{d_1^2(t) + d_2^2(t)} ;$$

zu erzeugen.

Eine solche Schaltung ist an sich bekannt, z.B. aus FERRANTI: Analog IC-Design, 1980. Sie weist zwei Reihenschaltungen von Transistoren T11, T12, T21 und T22 auf, deren Basen mit ihren Kollektoren verbunden sind, wobei an diesen Reihenschaltungen die zu verknüpfenden Eingangssignale $h_1(t)$ und $h_2(t)$ anliegen. Diese liegen weiters an den Basen zweier parallel geschalteter Transistoren T3, T4 an, zu denen ein weiterer Transistor T5 in Reihe geschaltet ist, dessen Basis mit dessen Kollektor verbunden ist. Dabei fließt über die parallel geschalteten Transistoren T3, T4 ein Strom $A(t)$ der

$$A(t) = V \overline{h_1^2(t) + h_2^2(t)}$$

entspricht, wobei $h_1(t)$ und $h_2(t)$ die Eingangsströme sind.

In der Fig 11 sind nebeneinander drei verschiedene Eingangssignale $u_i(t)$ dargestellt, wobei die Eingangssignale $u_i(t)$ in den ersten beiden mit I und II bezeichneten Fällen Sinusschwingungen und in dem mit III bezeichneten Fall eine modulierte Sinusschwingung darstellen.

In der Fig. 12 sind die zu den Eingangssignale $u_i(t)$ gehörigen momentanen Frequenzsignale $w(t)$ dargestellt. Es ist ersichtlich, daß die Frequenz in den Fällen II und III doppelt so hoch ist wie im ersten Fall I.

Die Fig. 13 zeigt die momentanen Amplitudensignale $A(t)$. Im Fall II ist die Amplitude halb so groß wie im Fall I. Beim dritten Fall III hingegen schwankt die momentane Amplitudenfuktion periodisch.

Fig.14 zeigt Ausgangssignale $v_0(t)$, die Schaltungen der Fig. 1 bis 3 entsprechen. Dabei ist angenommen, daß die Schaltung so abgestimmt ist, daß die Frequenz des Eingangssignales $u_i(t)$ verdoppelt wird. Die Amplitude des Ausgangssignales $v_0(t)$ ist unabhängig von der des Eingangssignales $u_i(t)$. Auch bei den Ausgangssignalen $u_0(t)$ von Fig. 15 ist die Frequenz verdoppelt. Ein solches Signal $u_0(t)$, das etwa mit der Schaltung von Fig. 4 gewonnen werden kann, weist jedoch die gleiche Amplitude wie das Eingangssignal $u_i(t)$ auf, was einsichtig ist, wenn man bedenkt, daß das Signal $v(t)$ konstanter Amplitude mit dem Amplitudensignal multipliziert wird. Nichtlineare Verzerrungen sind in den Fig. 14 und 15 nicht berücksichtigt.

**Patentansprüche**

1. Verfahren zur Verschiebung der Frequenz von Signalen $u(t)$, bestehend aus folgenden Schritten:
   - Erzeugung eines analytischen Signales, bestehend aus zwei Hilbert-Signalen $h_1(t)$, $h_2(t)$, dessen Energiespektrum dem des Eingangssignales $u_i(t)$ entspricht;
   - Differenzierung und Verknüpfung der Hilbert-Signale $h_1(t)$ und $h_2(t)$ zur Erzeu-

gung eines momentanen Frequenzsignales w(t);

- Erzeugung eines Ausgangssignales $u_o(t)$ bzw. $v_o(t)$, dessen momentane Frequenz jeweils dem momentanen Frequenzsignal w(t) entspricht.

2. Verfahren nach Anspruch 1, dadurch gekennzeichnet, daß das momentane Frequenzsignal w(t) einer Regelung oder Steuerung unterworfen wird.

3. Verfahren nach einem der Ansprüche 1 oder 2, dadurch gekennzeichnet, daß das momentane Frequenzsignal w(t) nichtlinear verstärkt oder abgeschwächt wird.

4. Verfahren zur Verschiebung der Frequenz von Audio-Signalen u(t), insbesonders für Hörgeräte, nach einem der Ansprüche 1 bis 3, dadurch gekennzeichnet, daß das Ausgangssignal $v_o(t)$ mit einem spannungsgesteuerten Oszillator (VCO) erzeugt wird und im Anschluß mit einem momentanen Amplitudensignal A(t) multipliiert wird, dessen momentane Stärke im wesentlichen proportional der momentanen Amplitude des Eingangssignales $u_i(t)$ ist.

5. Verfahren nach Anspruch 4, dadurch gekennzeichnet, daß das momentane Amplitudensignal A(t) vor der Multiplikation nichtlinear verstärkt oder abgeschwächt wird.

6. Verfahren zur Erzeugung eines momentanen Frequenzsignales w(t) mit folgenden Schritten:
    - Erzeugung eines analytischen Signales, bestehend aus zwei Hilbert-Signalen $h_1(t)$, $h_2(t)$, dessen Energiespektrum dem des Eingangssignales $u_i(t)$ entspricht;
    - Differenzierung der beiden Hilbert-Signale $h_1(t)$, $h_2(t)$;
    - Bildung der Quadratwurzel wA(t) aus der Summe der Quadrate der differenzierten Signale $d_1(t)$ und $d_2(t)$ ;
    - Division des so erhaltenen Signales wA(t) durch ein momentanes Amplitudensignal A(t), dessen Stärke im wesentlichen proportional zur momentanen Amplitude des Eingangssignales $u_i(t)$ ist.

7. Verfahren nach Anspruch 6, dadurch gekennzeichnet, daß das momentane Amplitudensignal A (t) dadurch gewonnen wird, daß die Quadratwurzel aus der Summe der Quadrate der beiden Hilbert-Signale $h_1$ (t) und $h_2$ (t) gebildet wird.

8. Verfahren zur Erzeugung eines momentanen Frequenzsignales w'(t) mit folgenden Schritten:

- Erzeugung eines analytischen Signales, bestehend aus zwei Hilbert-Signalen $h_1(t)$, $h_2(t)$, dessen Energiespektrum dem des Eingangssignales $u_i(t)$ entspricht;
- Differenzierung der beiden Hilbert-Signale $h_1(t)$ und $h_2(t)$;
- Addition der Beträge der differenzierten Signale $d_1(t)$ und $d_2(t)$;
- Division des so erhaltenen Signals H(t) durch die Summe G(t) der Beträge der beiden Hilbert-Signale $h_1(t)$ und $h_2(t)$.

9. Vorrichtung zur Verschiebung der Frequenz von Signalen u(t) mit einer Frequenzsignalschaltung (FSS), mit der ein momentanes Frequenzsignal w(t) erzeugbar ist, sowie mit einem spannungsgesteuerten Oszillator (VCO), der an den Ausgang der Frequenzsignalschaltung (FSS) angeschlossen ist.

10. Vorrichtung nach Anspruch 9, dadurch gekennzeichnet, daß zwischen der Frequenzsignalschaltung (FSS) und dem spannungsgesteuerten Oszillator (VCO) ein Regler (R) und/oder ein nichtlineares Übertragungsglied (NLP, $NLP_1$) eingefügt ist.

11. Vorrichtung zur Verschiebung der Frequenz von Audio-Signalen u(t), insbesonders für Hörgeräte, mit:
    - einer analytischen Schaltung (AS), mit der ein momentanes Frequenzsignal w(t) und ein momentanes Amplitudensignal A(t) erzeugbar sind,
    - einem spannungsgesteuerten Oszillator (VCO), der an dem das Frequenzsignal w(t) liefernden Ausgang der analytischen Schaltung (AS) angeschlossen ist.
    - einem Multiplizierer (M) mit zwei Eingängen, von denen einer an den Ausgang des spannungsgesteuerten Oszillators (VCO) und der andere an dem das momentane Amplitudensignal A(t) liefernden Ausgang der analytischen Schaltung (AS) angeschlossen ist.

12. Vorrichtung nach Anspruch 11, dadurch gekennzeichnet, daß zwischen dem Multiplizierer (M) und dem das Amplitudensignal A(t) liefernden Ausgang der analytischen Schaltung (AS) ein nichtlineares Übertragungsglied ($NLP_2$) vorgesehen ist.

13. Vorrichtung nach einem der Ansprüche 9 bis 12, dadurch gekennzeichnet, daß die Frequenzsignalschaltung (FSS) folgende Bestandteile aufweist:
    - eine Hilbert-Schaltung (HS) mit zwei Ausgängen, an denen zwei aus einem Eingangssignal $u_i(t)$ gewonnene Hilbert-Signale $h_1(t)$ und $h_2(t)$ anliegen, die die beiden Komponenten eines analytischen Signales darstellen;

- zwei Differenzierglieder ($D_1$ und $D_2$), die an die Ausgänge der Hilbert-Schaltung (HS) angeschlossen sind;

- eine erste Verknüpfungsschaltung ($VS_1$), die mit ihren beiden Eingängen an die Ausgänge der Hilbert-Schaltung (HS) angeschlossen ist und die bei an den Eingängen anliegenden Signalen $h_1(t)$ und $h_2(t)$ ein Ausgangssignal A(t) nach folgendem Algorithmus erzeugt:
$$A(t) = V \overline{h_1{}^2(t) + h_2{}^2(t)} ;$$

- eine zweite Verknüpfungsschaltung ($VS_2$), die mit ihren beiden Eingängen an die Differenzierglieder ($D_1$ und $D_2$) angeschlossen ist und die bei an den Eingängen anliegenden Signalen $d_1(t)$ und $d_2(t)$ ein Ausgangssignal wA(t) nach folgendem Algorithmus erzeugt:
$$wA(t) = V \overline{d_1{}^2(t) + d_2{}^2(t)} ;$$

- eine Divisionsschaltung (DS), die mit ihren Eingängen an die Verknüpfungsschaltungen ($VS_1$ und $VS_2$) angeschlossen ist und die ein Ausgangssignal w(t) nach folgender Formel erzeugt:
$$w(t) = wA(t) / A(t) .$$

14. Vorrichtung nach einem der Ansprüche 9 bis 12, dadurch gekennzeichnet, daß die Frequenzsignalschaltung (FSS) folgende Bestandteile aufweist:

- eine Hilbert-Schaltung (HS) mit zwei Ausgängen, an denen zwei aus einem Eingangssignal $u_i(t)$ gewonnene Hilbert-Signale $h_1(t)$ und $h_2(t)$ anliegen, die die beiden Komponenten eines analytischen Signales darstellen;

- zwei Differenzierglieder ($D_1$ und $D_2$), die an die Ausgänge der Hilbert-Schaltung (HS) angeschlossen sind;

- einen ersten Betrags-Addierer ($BA_1$), der mit seinen beiden Eingängen an die Ausgänge der Hilbert-Schaltung (HS) angeschlossen ist und der bei an den Eingängen anliegenden Signalen $h_1(t)$ und $h_2(t)$ ein Ausgangssignal G(t) nach folgendem Algorithmus erzeugt:
$$G(t) = | h_1(t) | + | h_2(t) | ;$$

- einen zweiten Betrags-Addierer ($BA_2$), der mit seinen beiden Eingängen an die Differenzierglieder ($D_1$ und $D_2$) angeschlossen ist und der bei an den Eingängen anliegenden Signalen $d_1(t)$ und $d_2(t)$ ein Ausgangssignal H(t) nach folgendem Algorithmus erzeugt:
$$H(t) = | d_1(t) | + | d_2(t) | ;$$

- eine Divisionsschaltung (DS), die mit ihren Eingängen an die beiden Betrags-Addierer ($BA_1$ und $BA_2$) angeschlossen ist und die ein Ausgangssignal w'(t) nach folgender Formel erzeugt:
$$w'(t) = H(t) / G(t) .$$

15. Vorrichtung nach einem der Ansprüche 13 bis 14, dadurch gekennzeichnet, daß die Hilbert-Schaltung (HS) aus mindestens zwei Allpässen ($AP_1$, $AP_2$) besteht.

16. Vorrichtung nach Anspruch 15, dadurch gekennzeichnet, daß eine Frequenzweiche (FW) vorgesehen ist, deren Ausgänge mit mehreren Paaren von Allpässen ($AP_1$, $AP_2$; $AP_3$, $AP_4$) verbunden sind.

Fig. 1

Fig. 2

Fig. 3

Fig. 4

9

Fig. 5

Fig. 6

Fig. 7

Fig. 8

Fig. 9

Fig. 10

Fig. 11

$U_i$  I          II          III

Fig. 12

$\omega(t)$

Fig. 13

$A(t)$

Fig. 14

$V_o(t)$

Fig. 15

$U_o(t)$

Europäisches
Patentamt

Nummer der Anmeldung

EP    92 89 0239

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 562 354 (LMT RADIO PROFESSIONNELLE, S.A)<br>* Zusammenfassung; Abbildung 1 *<br>--- | 1 | H03D7/16 |
| A | PATENT ABSTRACTS OF JAPAN<br>vol. 013, no. 390 (E-813)29. August 1989<br>& JP-A-11 36 407 ( HITACHI LTD. ) 29. Mai 1989<br>* Zusammenfassung *<br>--- | 6-8, 13-15 | |
| A | US-A-4 461 025 (FRANKLIN)<br>* Zusammenfassung; Abbildung 1 *<br>* Spalte 4, Zeile 34 - Zeile 44 *<br>* Spalte 7, Zeile 20 - Zeile 33 *<br>--- | 11 | |
| A | PATENT ABSTRACTS OF JAPAN<br>vol. 006, no. 205 (E-136)16. Oktober 1982<br>& JP-A-57 113 646 ( HISAO OIKAWA ) 15. Juli 1982<br>* Zusammenfassung *<br>--- | 16 | |
| A | EP-A-0 329 383 (AVR COMMUNICATIONS LTD.)<br>* das ganze Dokument *<br><br>----- | | |

**RECHERCHIERTE SACHGEBIETE (Int. Cl.5)**

H03D
G10L
H03G
H04R
H04J
H03F

Der vorliegende Recherchenbericht wurde für alle Patentansprüche erstellt

| Recherchenort | Abschlußdatum der Recherche | Prüfer |
|---|---|---|
| BERLIN | 22 FEBRUAR 1993 | DANIELIDIS S. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.......................................................................
& : Mitglied der gleichen Patentfamilie, übereinstimmendes
    Dokument